# EUROPEAN PATENT SPECIFICATION

(11) **EP 2 594 882 B1**
(45) Date of publication and mention of the grant of the patent: **09.12.2015**
(21) Application number: 12160461.5
(22) Date of filing: 21.03.2012
(51) Int. Cl.: F27B 17/00, C23C 16/44, H01L 21/67

(54) **Vertical Heat Treating Furnace**
Vertikaler Wärmebehandlungsofen
Four de traitement thermique vertical

(30) Priority: 17.11.2011 TW 100142148
(43) Date of publication of application: 22.05.2013
(73) Proprietor: Kern Energy Enterprise Co., Ltd., Taipei City 110 (TW); Yoshimura, Toshiaki, Iruma-shi, Saitama (JP)
(72) Inventor: Yoshimura, Toshiaki, Iruma-shi, Saitama (JP); Hsiao, Ying-Shih, 110 Taipei City (TW)
(74) Representative: Lang, Christian

(56) References cited:
- US-A1- 2009 095 422
- US-A1- 2010 297 832
- US-B1- 6 187 102

## Description

### BACKGROUND OF THE INVENTION

### 1. Field of the Invention

This invention relates to a heat treating furnace, and more particularly to a vertical heat treating furnace capable of performing heat treatments under high pressure. The vertical heat treating furnace provides a double-chamber structure including a gas circulation chamber and a reaction chamber. By controlling the relative gas density and pressure of the chambers, the reaction gases inside the reaction chamber of the vertical heat treating furnace can be mixed uniformly and the reaction could be facilitated under high pressure. Hence the quality of the formed thin film and the operational safety are improved.

### 2. Description of the Prior Art

With the development of compound thin film solar cell technologies, the thin film fabrication equipments for developing the thin film or the thin film precursor on substrates have been used in generating more and more products. However, the present methods of developing the thin film include spattering and co-evaporation. Especially for fabricating the products which are mass produced successfully in thin-film photovoltaic industry, spattering is the most commonly used technique in developing the thin film precursor prior to the chemical reaction process for forming the thin film.

Furthermore, among the techniques of performing chemical reaction processes on the thin film precursor for forming thin films, providing chemical compound vapor is the most suitable method for mass production. It is an advantageous way of providing chemical compound vapor to supply the required elements for forming the thin film precursor, such that the concentration and the diffusion of ingredients for forming the thin film precursor can be accurately controlled. As a result, the development of techniques and equipments of performing chemical reactions for forming thin films which employ the heat treating furnace grows vigorously. Taking the selenization process of Copper Indium Gallium Diselenide (CIGS) solar cell as an example, the spattering deposition technique is used for forming multiple-layer precursors containing alloys or monomers of copper (Cu), gallium (Ga) and indium (In) on a soda lime glass substrate to constitute the structure of CIGS solar cell. Then the layered structure for producing CIGS solar cell is transferred into a selenization furnace (i.e. heat treating furnace), and the gaseous hydrogen selenide (H₂Se) is introduced into the selenization furnace and is heated to the temperature of 400°C or a higher tempareture to start the reaction between the gaseous hydrogen selenide and the multiple-layer precursors. However, the selenization process of CIGS solar cell fabrication, heating the solar cell structure with multiple-layer thin films is required for reacting with gaseous hydrogen selenide to produce the high-quality CIGS films. For example, a copper-gallium (Cu-Ga) alloy layer, a copper-indium (Cu-In) alloy layer and an indium layer are deposited to form the three-layer CuGa/CuIn/In precursor film of uniform thickness. The three-layer CuGa/CuIn/In precursor film is transferred into a selenization furnace immediately after the deposition. Then the gaseous hydrogen selenide is introduced and the three-layer CuGa/CuIn/In precursor film is heated to the temperature of 400°C at the heating rate of 40°C/min, and the three-layer CuGa/CuIn/In precursor film is reacted with selenide to form a compound CIGS layer. The compound CIGS layer is then heated to 550°C at the heating rate of 15°C/min to provide the optimal crystal structure, followed by a step of cooling, and the compound CIGS layer is formed.

Due to that the selenization process is performed at the temperature range of 520 to 590°C, a large thick quartz tubes is utilized to be the inner body in the conventional heat treating furnace, and the outer side is tightly contacted to the thermal insulating materials, as a result, inside the heat treating furnace is in a closed status. In addition, the effects of thermal expansion and contraction makes the reaction gas with higher temperature flowing upward and the reaction gas with lower temperature flowing downward, which result in poor gas mixing in the selenization process, thus further result in variant quality and the thickness of the compound CIGS layer on the glass substrate. Furthermore, the reaction gases such as hydrogen selenide used in the selenization process are toxic; therefore the pressure inside the selenization furnace needs to be controlled at low pressure (i.e. lower than 1 atm) throughout the whole selenization process for the safety considerations and avoids the leakage of reaction gases otherwise causes industrial safety concerns. In this situation, the selenization process under low pressure evokes insufficient total gas molecules and results in the deterioration of the temperature gradient inside the selenization furnace, and also deteriorates the gas mixing uniformity. Those events result in a vicious circle that slow down the reaction rate and simultaneously worsen the uniformity of thin film. Apparently, the low pressure and the non-uniform temperature of present selenization furnaces generally result in the problems of selenium gas heterogeneity and ineffective thin film formation, thus the ultimate difficulty of promoting the photovoltaic conversion efficiency.

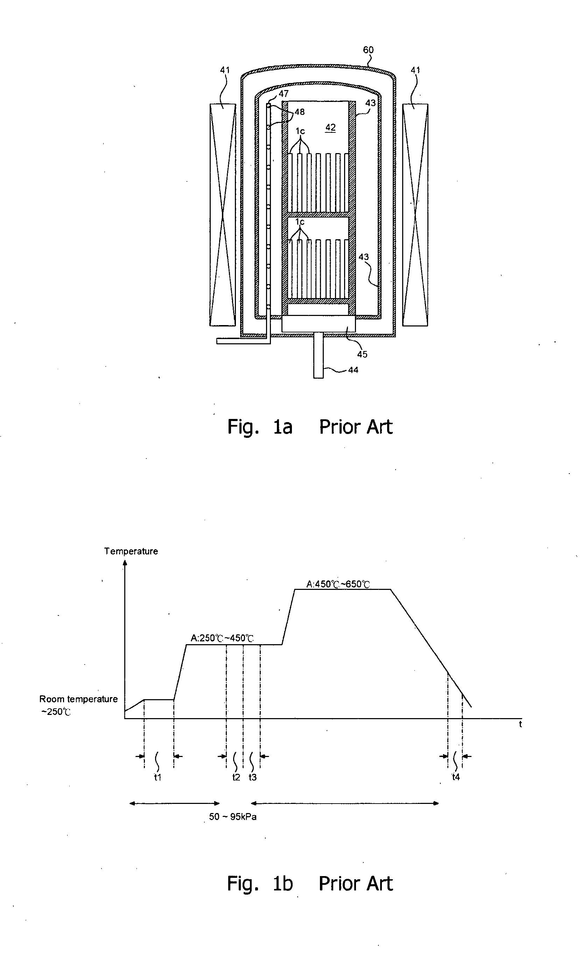

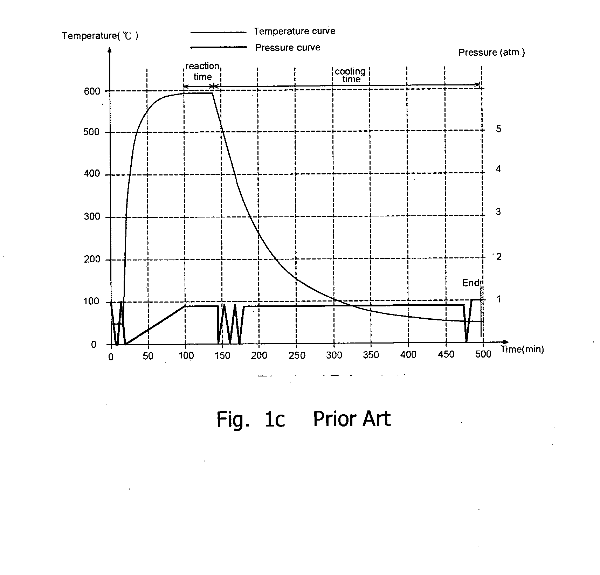

Please refer to the Fig. 1a and 1b. Fig.1a and 1b show schematically a prior art the embodiment of US7871502 patent. Referring to Fig. 1a, the selenization furnace includes only one closed reaction chamber provided for the selenization process of compound CIGS, and the pressure inside the chamber is kept lower than 1 atm throughout the whole selenization process. Fig. 1b shows the temperature profile diagram of selenization process. Fig. 1c shows the temperature and the pressure profile of the selenization process inside the selenization furnace shown in Fig. 1a. After closing the selenization furnaces, repeatedly pumping out the air inside the selenization furnace and pumping gaseous nitrogen into the reaction chamber is required to ensure that the reaction chamber is full of gaseous nitrogen. The operational pressure of reaction chamber of the conventional selenization furnace is kept at low pressure (i.e. lower than 1 atm) concerning the safety. The pressure in the reaction camber is controlled within a range of 0.8 to 0.9 atm throughout the whole reaction process. The gaseous pressure inside the reaction chamber increases as the selenization furnace is heated to the temperature of 590°C, thus, the gas is eliminated repeatedly for the purpose of reducing the pressure to maintain the pressure inside the reaction chamber at a set point. However, during the process of gas elimination, energy and excessive gas are wasted. When the temperature reaches the set point for reaction, the reaction gases are introduced simultaneously into the reaction chamber. Generally, hydrogen selenide (10%) and gaseous nitrogen (90%) which is the carrier gas are used for reaction. As shown in Fig. 1c, the reaction time of selenization is less than 100 minutes, but apparently the gas flows in the reaction chamber cannot be convected and the temperature cannot be uniformed in such short reaction time. Therefore, the uniformity of selenization is deteriorated which causes the variant thickness and quality of the compound CIGS layer on the substrates.

Following the reaction of forming the compound CIGS layer, the selenization furnace needs to be cooled down to transfer the CIGS solar cell substrate out of the selenization furnace. However, the reaction chamber of the inner body is a closed space, the only way to cool down the selenization furnace is pumping the gaseous nitrogen into inner body of the furnace and pumping out the gas at the same time which is a time consuming cooling process for reducing the temperature inside the selenide surface to the room temperature. As shown in Fig. 1c, this cooling process generally takes 5 to 8 hours, but when it comes to a larger substrate, it takes even more than 10 hours. Thus, tremendous manpower and resources are required, resulting in retarding the fabrication.

US 2010/298732 A1, US 6,187,102 B1 and US 2009/95422 A1 disclose examples of conventional heat treating devices, which include a reaction chamber and a gas circulation chamber surrounding the reaction chamber.

### SUMMARY OF THE INVENTION

To solve the above mentioned drawbacks, an objective of this invention is to design a vertical heat treating furnace provided with a gas circulation chamber between an inner body and outer body to maintain a pressure difference therein. Thus the density of gas molecules or the gaseous pressure inside the inner body can be increased to facilitate the chemical reaction rate of the thin film and improve the uniformity of the thin film.

Another objective of this invention is to provide a gas circulation chamber in the vertical heat treating furnace for simultaneously introducing the cooling gaseous nitrogen into a reaction chamber inside the inner body and the gas circulation chamber between the inner body and the outer body, and therefore facilitating the flow rate of gaseous nitrogen and effectively accelerating cooling rate.

A further objective of this invention is to provide a gas circulation chamber in the vertical heat treating furnace for simultaneously introducing the cooling gaseous nitrogen into a reaction chamber inside the inner body and the gas circulation chamber between the inner body and the outer body, and therefore preventing the formation of temperature gradient in the wall of inner body, and effectively protecting the wall of inner body from chapping or peeling.

A further objective of this invention is to provide a gas circulation chamber in the vertical heat treating furnace for filling the gaseous nitrogen to keep a first pressure (P₁) in the gas circulation chamber greater than a second pressure (P₂) in the reaction chamber of the inner body. A safety gate door is provided to effectively protect the operator from the danger of pressure imbalance inside the vertical heat treating furnace.

A further objective of this invention is to provide a gas circulation chamber in the vertical heat treating furnace which improves the operational safety, for raising the operational pressure without the limitation of low pressure (i.e. < 101325 Pa (1atm)) so that the operation can be performed at a higher pressure (i.e. > 101325 Pa (1atm)). In this way, the reaction rate and uniformity are improved and the waste of reaction gas is further reduced.

A further objective of this invention is to provide a vertical heat treating furnace provided with a sensor for real-time monitoring the pressure in the reaction chamber inside the inner body and the gas circulation chamber during the process of forming the thin film. It enables the effective control of the gas inflow to improve the safety and efficiency of the thin film formation.

A further objective of this invention is to provide a vertical heat treating furnace which a controlling method is chosen from monitoring the pressure or gas density in the reaction chamber by a pressure gauge or a gas density analyzer, and the signal is transmitted to a controlling device for the following regulation so as to increase the production profit and reduce the waste of excessive gas.

The above mentioned objects are solved by the vertical heat treating furnace according to claim 1. Advantageous improvements are described by the dependent claims.

According to the aforementioned objectives, the present invention provides a vertical heat treating furnace including an outer body having an exterior wall and an interior wall, thereby forming a first receiving space, and having a first side and a second side corresponding to the first side, the first side being provided with an opening of the first receiving space, the second side is a sealed side. The vertical heat treating furnace further includes an inner body spaced and fixed in the first receiving space of the outer body, having an outer wall and an inner wall, thereby forming a second receiving space. The inner body further has a third side and a fourth side corresponding to the third side, and a part of the third side being connected with the first side by a lower sealed side thereby forming an opening of the second receiving space, and the fourth side is a sealed side, wherein a gas circulation chamber is formed between the outer wall of the inner body and the interior wall of the outer body, a reaction chamber being formed inside the inner wall of the inner body. The vertical heat treating furnace further includes a gate door which has an outer surface and an inner surface, being contacted with the opening of the second receiving space of the third side by the inner surface, thereby either of the gas circulation chamber and the reaction chamber being an independent chamber.

The present invention further provide a vertical heat treating furnace including an outer body having an exterior wall and an interior wall, thereby forming a first receiving space, and having a first side and a second side corresponding to the first side, the first side being provided with an opening of the first receiving space, the second side is a sealed side. The vertical heat treating furnace further includes an inner body spaced and fixed in the first receiving space of the outer body, having an outer wall and an inner wall, thereby forming a second receiving space. The inner body further has a third side and a fourth side corresponding to the third side, and a part of the third side being connected with the first side by a lower sealed side thereby forming an opening of the second receiving space, and the fourth side is a sealed side, wherein a gas circulation chamber is formed between the outer wall of the inner body and the interior wall of the outer body, a reaction chamber being formed inside the inner wall of the inner body. The vertical heat treating furnace further includes a heating mechanism being fixed and contacted with the outer wall of the inner body. The vertical heat treating furnace further includes a gate door which has an outer surface and an inner surface, being contacted with the opening of the second receiving space of the third side by the inner surface, thereby either of the gas circulation chamber and the reaction chamber being an independent chamber. The vertical heat treating furnace further includes a gas supplying mechanism constituted by a plurality of gas pipes which pass through the outer surface and the inner surface of the gate door, thereby introducing gases into the gas circulation chamber and the reaction chamber via the opening of the second receiving space and the lower sealed side. The vertical heat treating furnace further includes a controller set outside the outer body for controlling the gas supplying mechanism, thereby controlling the supply amount of a first gas and a second gas into the gas circulation chamber and the reaction chamber. Thereby the gases form a first pressure (P₁) in the gas circulation chamber, and forming a second (P₂) in the reaction chamber.

The present invention provides the vertical heat treating furnace with the design of gas circulation chamber, enabling effective protection of operators, saving manpower and resources, and providing the reaction environment for high-pressure gases, those which are advantageous for forming various thin films.

### BRIEF DESCRIPTION OF THE DRAWINGS

Fig. 1a is a schematic diagram illustrating the prior art;
Fig. 1b is a schematic diagram illustrating the prior art;
Fig. 1c is a schematic diagram of the temperature and pressure profile in the prior art;
Fig. 2a is a schematic diagram representing an embodiment of the vertical heat treating furnace in the present invention;
Fig. 2b is a schematic diagram representing an embodiment of the closed vertical heat treating furnace in the present invention;
Fig. 3 is a schematic diagram representing the cross-sectional view of an embodiment of the vertical heat treating furnace in the present invention;
Fig. 4 is a schematic diagram representing the controlling profile of pressure and temperature of the vertical heat treating furnace in the present invention;
Fig. 5 is a schematic diagram representing the controlling profile of gas density and temperature of the vertical heat treating furnace in the present invention.

### DESCRIPTION OF THE PREFERRED EMBODIMENT

The present invention discloses the structure and function of a heat treating furnace. For the convenience of description, an example of a heat treating furnace producing CIGS solar cells is described for illustration, wherein the structure and function of a heat treating furnace producing CIGS solar cells are well known by persons skilled in the art and the description emphasizes the features of the heat treating furnace of the present invention, and thus is not described in detail hereunder. The drawings below, with which the description presented hereunder is illustrated, are intended to depict schematically the structures related to the features of the present invention and are not, and need not being, drawn to scale.

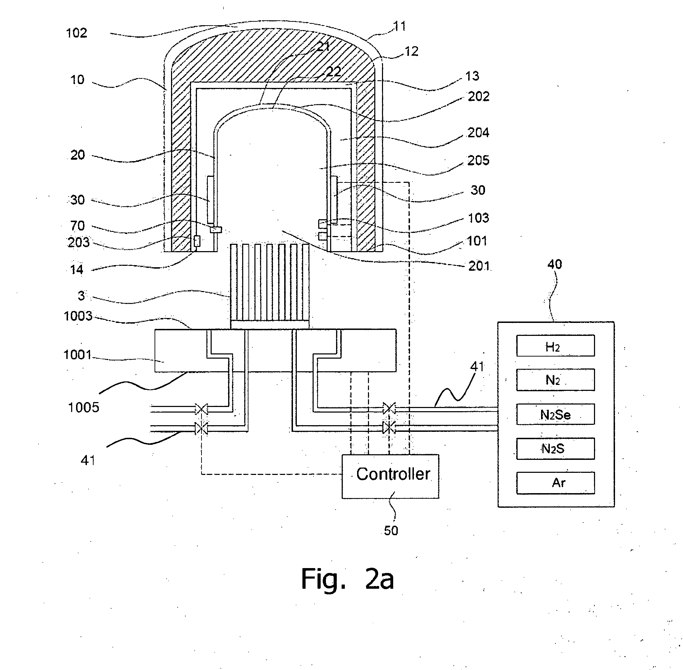

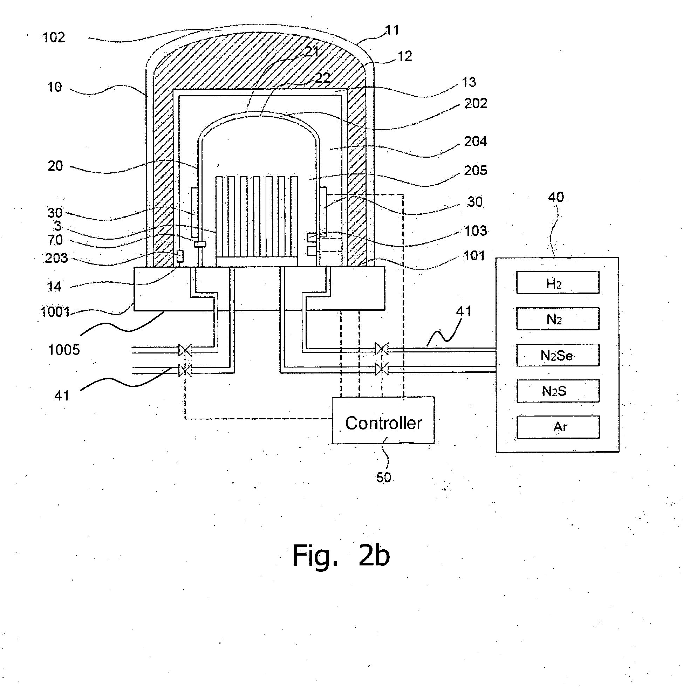

First, refer to Fig. 2a schematically represents an embodiment of the vertical heat treating furnace in the present invention. As shown in Fig. 2, the structures of the vertical heat treating furnace include an outer body 10 which has an exterior wall 11 and an interior wall 12 for forming a first receiving space. The vertical heat treating furnace has a first side 101 and a second side 102 corresponding to the first side 101. An opening of the first receiving is provided in the first side 101, and the second side 102 is an upper sealed side 13, such as an sealed side having arcs. The vertical heat treating furnace includes an inner body 20 which is spaced and fixed in the first receiving space of the outer body 10, and has a second receiving space formed by an outer wall 21 and an inner wall 22. The inner body 20 has a third side 201 and a fourth side 202 corresponding to the third side 201, wherein a part of the third side 201 is connected with the first side 101 by a lower sealed side 14 thereby forming an opening of the second receiving space, and the fourth side 202 is also a sealed side, wherein a gas circulation chamber 204 is formed between the outer wall 21 of the inner body 20 and the interior wall 12 of the outer body 10; a reaction chamber 205 is formed inside the inner wall 22 of the inner body 20. The vertical heat treating furnace further includes a gate door 1001 which has which has an outer surface 1005 and an inner surface 1003. When the thin film solar cell substrate 3 is disposed on the inner surface 1003 and the gate door is closed, the gas-tight structure (not shown) provided in the gate door 1001 is hermetically sealed with the opening of the second receiving space of the third side 201, thereby making either of the gas circulation chamber 204 and the reaction chamber 205 to be an independent gas-tight chamber without any communication with the thin film solar cell substrate 3 being located in the reaction chamber 205 as shown in Fig. 2b.

The vertical heat treating furnace includes a heating mechanism 30 fixed and contacted with the outer wall 21 of the inner body 20; a gas supplying mechanism 40 constituted by a plurality of gas pipes 41 which pass through the outer surface 1005 and the inner surface 1001 of the gate door, thereby introducing gases into the gas circulation chamber 204 and the reaction chamber 205 via the opening of the second receiving space and the lower sealed side 14. The gas supplying mechanism 40 provides at least one first gas (such as nitrogen N₂ and argon Ar) into the gas circulation chamber 204; and provide at least one second gas (such as hydrogen H₂, nitrogen N₂, hydrogen selenide H₂Se, hydrogen sulfide H₂S and argon Ar) into the reaction chamber 205. The vertical heat treating furnace further includes a controller 50 set outside the outer body 10 for controlling the gas supplying mechanism 40, thereby controlling the supply amount of a first gas and a second gas into the gas circulation chamber 204 and the reaction chamber 205. Thereby the gases form a first pressure (P₁) in the gas circulation chamber 204, and forming a second (P₂) in the reaction chamber 205.

Refer to Fig. 2b schematically represents an embodiment of the closed vertical heat treating furnace in the present invention. As shown in Fig. 2, when the gate door 1001 is closed, the gas-tight structure (not shown) provided in the gate door 1001 is hermetically sealed with the opening of the second receiving space of the third side 201, thereby making either of the gas circulation chamber 204 and the reaction chamber 205 to be an independent gas-tight chamber without any communication with the thin film solar cell substrate 3 being located in the reaction chamber 205. Then, the thin film solar cell substrate 3 is located in the vertical heat treating furnace 1 for forming compound CIGS layers, and during this process, introducing the gaseous hydrogen selenide (H₂Se) into the reaction chamber 205 of the inner body 20 is required, and the fabrication under high temperature and high pressure is required to form the fairly uniform compound CIGS layers on the thin film solar cell substrate 3. Furthermore, due to the gaseous hydrogen selenide (H₂Se) introduce into the reaction chamber 205 reacts with air and generates selenium dioxide (SeO₂) dust which contaminate the compound CIGS layer and the inner wall 22 of the inner body 20, those which are hazardous to operators. Therefore, during the process of reaction, either the gas circulation chamber 204 between the outer body 10 and the inner body 20 or the reaction chamber 205 between the inner wall 22 of the inner body 20 is required to be independent and gas-tight sealed chamber. Based on the requirement, the outer body 10 is made of steel or stainless steel such as SUS304 and SUS316 which enables the outer body 10 is resistant to a pressure of 20 atm. However, the material used to make the outer body 10 is not limited in the present invention. Moreover, the thermal insulating material can be further provided on the inner wall 12 of the outer body 10 to disrupt the transmission of heat to the outer wall 11 of the outer body 10 during the heating process. And the thermal insulating material can be any heat-resistant material such as quartz bricks or mica brick. Furthermore, for the reasons that the inner body 20 is operated under high pressure and temperature, and the reaction gases may be corrosive, the inner wall 22 of the inner body 20 may be made of quartz or silicon dioxide (SiO₂), and a SiO₂ layer can be similarly formed on the lateral side of the inner surface 1003 of the first gate door 1001, which is contacted hermetically with the gas-tight structure of the third side 201, to protect the first gate door 1001.

Refer to Fig 2b again, the gas circulation chamber 204 is provided with at least one first sensor 103 and each of the first sensor 103 is connected with a controller 50. Meanwhile, the reaction chamber 205 is also provided with at least one second sensor 203 and each of the second sensor 203 is connected with a controller 50. When both the first sensor 103 and the second sensor 203 are pressure gauges, the pressure measured in the gas circulation chamber 204 (P₁) and the pressure measured in the reaction chamber 205 (P₂) are transmitted to the controller 50 and then the pressure difference (P₁- P₂) is calculated by the controller 50 and is accordingly controlled. It should be especially emphasized that the purpose of calculating the pressure difference (P₁ - P₂) basing on the measurement of the first sensor 103 in the gas circulation chamber 204 and the second sensor 203 in the reaction chamber 205 of present invention is to control the pressure difference (P₁ - P₂) precisely and practically; especially to control the outer pressure of the gas circulation chamber 204 slightly greater than the inner pressure of the reaction chamber 205. For example, in an embodiment of the present invention, the original pressure difference is set at 1Kg/cm², and once the value of pressure difference is greater than 1Kg/cm², the controller 50 immediately adjusts and increases the amount of gas input in the reaction chamber 205 and reduces the amount of gas input in the gas circulation chamber 204, thereby maintaining the pressure difference within a predetermined range. And in the preferred embodiment of the present invention, the outer pressure of the gas circulation chamber 204 is greater than 101325 Pa (1 atm). With the safety consideration, obviously, the control of the pressure difference is executed by simultaneously controlling the gas input in both chambers (i.e. the gas circulation chamber and the circulation chamber). Additionally, when controlling the gas density is employed in this embodiment, the first sensor 103 and the second sensor 203 can be gas density analyzers. Moreover, the first sensor 103 is a pressure gauge while the second sensor is a gas density analyzer to control the vertical heat treating furnace 1, such that users may choose to control the pressure or control the density depending on the practical case itself, which is not limited in the present invention.

Accordingly, the gas supplying mechanism 40 is set outside the outer body 10, being constituted by a plurality of gas pipes 41 passing through the inner surface 1003 of the gate door 1001, and is contacted with the lower side of the outer body and with the outer wall of the inner body 20. A plurality of gas pipes 41 of the gas supplying mechanism 40 is connected to the controller 50 to provide and control the supply of at least one first gas (such as nitrogen N₂ and argon Ar) into the gas circulation chamber 204; and provide and control the supply of at least one second gas (such as hydrogen H₂, nitrogen N₂, hydrogen selenide H₂Se, hydrogen sulfide H₂S and argon Ar) into the reaction chamber 205 for proceeding reaction. It should be emphasized that, the controller 50 of the vertical heat treating furnace 1 in this invention keeps the first pressure (P₁) in the gas circulation chamber 204 being greater than the second pressure (P₂) in the reaction chamber 205 all the time when the vertical heat treating furnace is operated to perform a gas reaction. Or the controller 50 keeps the first density in the gas circulation chamber 204 being greater than the second density in the reaction chamber 205 all the time during the reaction. In an embodiment of the present invention, the first pressure (P₁) is kept within the range of 50662,5 Pa to 992985 Pa (0.5 to 9.8 atm). Furthermore, other than controlling the amount of gas inflow, the controller 50 of the present invention also monitors and controls the pressure, temperature, density, and toxicity, time, and gas types, etc. In other words, all the settings related to vertical heat treating furnace 1 are controlled and measured via the pressure sensor, density sensor, thermal sensor and toxicity sensor, and the signals are transmitted by the signal transmission circuit to the controller 50 for further processing.

Referring to Fig 2b again, showing that a safety gate door 70 is further set between the gas circulation chamber 204 and the circulation chamber 205. For example, the safety gate door 70 is set between the outer wall 21 and inner wall 22 of the inner body 20, wherein the span of the outer wall 21 and inner wall 22 o is 6 to 25 mm. Once the pressure in the reaction chamber 205 (P₂) becomes greater than the set pressure in the gas circulation chamber 204 (P₁), the safety gate door 70 ruptures, allowing the gases in the gas circulation chamber 204 and the reaction chamber 205 to communicate. Because the pressure in the gas circulation chamber 204 (P₁) is slightly greater than the pressure in the reaction chamber 205 (P₂), the flowing hydrogen selenide in the gas circulation chamber 204 is directed to the reaction chamber 205 instead of leaking outside the furnace. Furthermore, the safety gate door 70 prevents the vertical heat treating furnace 1 from being over pressured to damage the wall of quartz furnace. In the embodiment of the present invention, the working pressure in the reaction chamber 205 is generally maintained at 506625 Pa (5 atm), far lower than the pressure resistance threshold of 2026500 Pa (20 atm). Thus, the vertical heat treating furnace ensures the operational safety.

Refer to both Fig. 2a and Fig. 2b, the closing of the vertical heat treating furnace in the present invention depends on the upward or downward movement of the furnace body constituted by the outer body 10 and inner body 20, thereby the gas circulation chamber 204 formed by third side 201 is hermetically sealed with the gas-tight structure in the gate door 1001. The furnace body can be moved upward to expose the compound thin film solar cell substrate 3, and then the compound thin film solar cell substrate 3 can be transferred out. Apparently, the gate door 1001 of the vertical heat treating furnace 1 of the embodiment of the present invention is fixed, thus ensuring that the gas pipes 41 passing through the gate door 1001 will not leak gases.

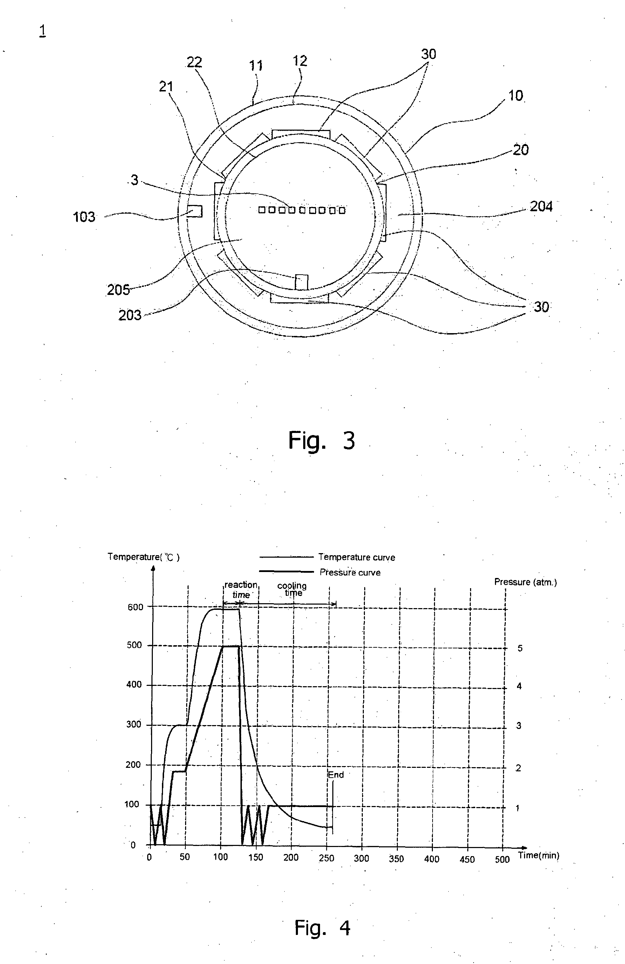

Refer to Fig. 3 schematically representing the cross-sectional view of an embodiment of the vertical heat treating furnace 1 in the present invention. As show in Fig. 3, the heating mechanism 30 of the vertical heat treating furnace 1 in the present invention is constituted by multiple of heaters arranged in the outer wall 21 of the inner body 20, next to the outer wall 21 of the inner body 20, wherein the heating mechanism 30 can be selected from a carbon heater or a halogen lamp heater, which heats the inner wall of the furnace to a set temperature. The carbon heater may provide electrical-resistance heating and the halogen lamp heater may provide infrared heating both of which heat the inner body 20 uniformly. In a preferred embodiment of the invention when the reaction gas is hydrogen selenide, the temperature reaches the range of 520°C to 590°C for performing the reaction. Referring to Fig. 2b, illustrating the location of the gas circulation chamber 204, the reaction chamber 205 and a substrate 3; apparently the compound thin film solar cell substrate 3 was introduced longitudinally in the reaction chamber 205 in coordination to the direction of gas flows inside, improve the uniformity of the reaction of thin film formation.

An embodiment is described here as an example to illustrate the safety design of the vertical heat treating furnace 1 of the present invention. Under an atmosphere pressure at 101325 Pa (1 atm), when a pressure at 303975 Pa (3 atm) is measured by the first sensor 103 in the gas circulation chamber 204; a pressure at 202650 Pa (2 atm) is measured by the second sensor 203 in the reaction chamber 205. That is to say, the pressure in the gas circulation chamber 204 is greater than both the pressure in the reaction chamber 205 and atmosphere pressure. Under this circumstance and given the pressure difference provided by the vertical heat treating furnace 1 of the present invention, once the gas leaks, only the gas in the gas circulation chamber 204 such as nitrogen leaks outside, and at the same time, the reduction of the pressure in the gas circulation chamber 204 thereby causes the controller to reduce the pressure in the reaction chamber 205 to maintain the pressure difference. Therefore, there is no safety concern for the operators. For the improvement of safety, the vertical heat treating furnace 1 of the present invention can be operated under normal, low and high pressures, wherein the preferred range of working pressure is 50662.5 Pa to 992985 Pa (0.5 to 9.8 atm). However, if the operational pressure in the gas circulation chamber 204 and the operational pressure in the reaction chamber 205 are both less than 101325 Pa (1 atm), for example, it is feasible to operate the vertical heat treating furnace 1 of the present invention when the pressure in the gas circulation chamber 204 is 101325 Pa (1 atm) and the pressure in the reaction chamber 205 is 99298.5 Pa (0.98 atm).

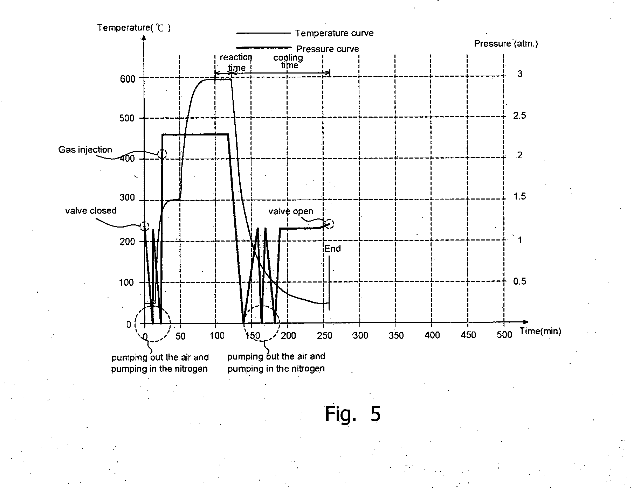

In addition, when both the first sensor 103 and the second sensor 203 are gas density analyzers, the reaction can be controlled by measuring the gas density. The way of controlling is based on the Boyle's law and the equation below: PₐVₐ/Tₐ=P_{b}V_{b}/T_{b} where Pₐ is the pressure, Vₐ is the volume and Tₐ is the temperature at point a; P_{b} is the pressure, V_{b} is the volume and T_{b} is the temperature at point b. The detail of the way of controlling will be described according to Fig. 4 and Fig. 5.

Refer to the Fig 4, schematically representing the controlling profile of pressure and temperature of the vertical heat treating furnace in the present invention. As shown in Fig. 4, after the first gate door 1001 and the second gate door 1002 being closed, the gas supplying mechanism 40 is controlled by the controller 50 to repeatedly pump out the air and pumps in the gas such as gaseous nitrogen inside the gas circulation chamber 204 and the reaction chamber 205, to ensure that no residual mist or water vapor. Meanwhile, the vertical heat treating furnace 1 is heated and the reaction gases are introduced into the reaction chamber 205. In this embodiment, hydrogen selenide (10%) and gaseous nitrogen (90%) which is the carrier gas are used for reaction. As shown in Fig. 4, during the heating process, after 50 minutes of reaction time, the temperature reaches a turning point (e.g. heating to 300°C), no more reaction gas is introduced and only the heating is continued. This operation is based on the Boyle's law and the equation below: PₐVₐ/Tₐ=P_{b}V_{b}/T_{b} where Pₐ is the pressure, Vₐ is the volume and Tₐ is the temperature at point a; P_{b} is the pressure, V_{b} is the volume and T_{b} is the temperature at point b. And the amount of reaction gas required in the reaction chamber 205 is determined prior to the operation, so that the introduction of the reaction gases is stopped one the amount of the reaction gases reaches to the setting value, and only the temperature is kept raising.

As the temperature being raised, the pressure in the reaction chamber 205 is increased fast. For example, as the temperature reaches 590°C, the pressure in the reaction chamber 205 reaches around 506625 Pa (5 atm), and then the reaction gases are reacting at 590°C under, thus the reaction are performed in this state. Obviously, at this time the controller 50 keeps the pressure in the gas circulation chamber 204 at 516757.5 Pa (5.1 atm). As shown in Fig. 4, only the reaction time of 20 minutes is required for completing the reaction. Immediately after the reaction, the fast cooling process is performed, meanwhile the controller 50 pumps out the residual non-reacting gas and then introduces the cooling gaseous nitrogen into the gas circulation chamber 204 and the reaction chamber 205 for cooling. The two walls of the inner body 20 in this embodiment of the present invention are cooled down simultaneously, which increases the cooling rate by two folds and reduces the concerns of chapping or peeling, thereby the input rate, amount of gas inflow, the cooling rate are accelerated to shorten the cooling time. Referring to Fig. 4 again, the vertical heat treating furnace 1 needs only 120 minutes to reduce the temperature of 590°C in the reaction chamber 205 to a range of 50 to 60 °C, and allows to open the first gate door 1001 to take out the compound solar cell substrate 3 with selenized compound CIGS layers.

As the process described previously, measuring the pressure is a way of the present invention for controlling, the pressure in the gas circulation chamber 204 measured by the first sensor 103 and the pressure in the reaction chamber 205 measured by the second sensor 203 are transformed into signals and transmitted to the controller 50 and then the pressure difference (P₁ - P₂) is controlled by the controller 50, which means the pressure in the gas circulation chamber 204 is kept being slightly greater than the pressure in the reaction chamber 205. Thus the reaction in the reaction chamber 205 is carried on smoothly. In this way, in the fast heating process of the vertical heat treating furnace 1 of the present invention, no depressurization is needed for fast heating, and the selenization can be performed under high pressure, for example, the reaction time is 20 minutes in this embodiment. Another advantage of the present invention is the fast cooling process, only a cooling time of 120 minutes is needed for reducing the temperature to the range of 50 to 60°C. Apparently, according to Fig. 4, not only the selenization time but the cooling time is greatly reduced the vertical heat treating furnace 1 of the present invention, therefore the usage rate of the vertical heat treating furnace 1 is greatly raised to reduce the production cost.

Refer to Fig. 5 schematically representing the controlling profile of the gas density and temperature of the vertical heat treating furnace in the present invention, the operation condition of the embodiment is described as following: the diameter of the inner body 20 is 1.1 m, depth is 2 m, the gas volume in the reaction chamber 205 of the inner body 20 is 1235 L. The Y axis in Fig. 5 represents the density, and after the first gate door 1001 being closed and nitrogen is introduced, the initial density is low due to the low density of nitrogen is lower than that of the air. A process of repeatedly pumping out the air and pumping in the nitrogen is completed to ensure no residual mist or water vapors inside, then the reaction gas, hydrogen selenide (10%) and gaseous nitrogen (90%, carrier gas) are introduced and following is the heating process. The controlling profile of pressure and temperature of the vertical heat treating furnace is similar to those in Fig. 4, during the heating process, after 50 minutes of reaction time, the temperature reaches a turning point (e.g. heating to 300°C), no more reaction gas is introduced into the reaction chamber 205. At the same time the amount of the reaction gas is constant in the reaction chamber 205. Corresponding to Fig. 4, the settings are shown as below: the temperature is at 590°C and the pressure is at 506625 Pa (5 atm). In this embodiment, the related gas densities in the vertical heat treating furnace are: the mean gas density is 2.35 kg/m³, the nitrogen density is 1.78 kg/m³, and the hydrogen selenide density is 0.57 kg/m³.

Referring Fig. 5 again, the reaction is performed under the mean gas density of 2.35 kg/m³, the controller 50 keeps the pressure in the gas circulation chamber 204 greater than 2.35 kg/m³ for the operation. Under the high gas density, the reaction rate is faster than conventional heat treating furnace, as shown in Fig. 5, the selenization in the reaction chamber 205 takes around 20 minutes. Likewise, the cooling nitrogen is introduced into the reaction chamber 205 inside the inner body 20 and the gas circulation chamber 204 outside the exterior wall of the furnace body, and there is no concern of the temperature gradient occurring in the wall of the inner body 20, which amplified the amount of gas inflow. Within less than 2 hours, the cooling process is completed. Once the gate door is opened, the temperature will be 25°C due to the air inflow in the reaction chamber 205, and the general air density is 1.184 kg/m³.

Due to that measuring the gas density is a way of the present invention for controlling, the gas density in the gas circulation chamber 204 and the reaction chamber 205 measured by the first sensor 103 and the second sensor 203 are transformed into signals and transmitted via the signal transmission circuit to the controller 50 and then the gas density difference is controlled by the controller 50, which means the gas density in the gas circulation chamber 204 is kept being slightly greater than the gas density in the reaction chamber 205. Thus the reaction in the reaction chamber 205 is carried on smoothly. In this way, during the fast heating process of the vertical heat treating furnace 1 of the present invention, no depressurization is needed for fast heating, and the selenization can be performed under high gas density (e.g. 2.35 kg/m³), accelerating the reaction. For example, the reaction time is 20 minutes in this embodiment. The other advantage of the present invention is the fast cooling process, only a cooling time of 120 minutes is needed for reducing the temperature to the range of 50 to 60°C. Apparently, according to Fig. 5, not only the selenization time but the cooling time is greatly reduced the vertical heat treating furnace 1 of the present invention, therefore the usage rate of the vertical heat treating furnace 1 is greatly raised to reduce the production cost.

Similarly, the first sensor 103 of the gas circulation chamber 204 can be a pressure gauge and the second sensor 203 of the reaction chamber 205 can be a gas density analyzer illustrated in Fig. 2a, and the signals measured by the pressure gauge or gas density analyzer can be transmitted to the controller 50 by the signal transmission circuit, to control and adjust the amount of gas inflows in the gas circulation chamber 204 and the reaction chamber 205. Therefore the vertical heat treating furnace of the present invention can be controlled according to the pressure or the density depending on the practical case.

All the above descriptions are based on the example of CIGS thin film solar cell substrate 3. However, the vertical heat treating furnace of the present invention can also be applied in other kinds of fabrication. Taking the Copper Zinc Tin Sulfide (CZTS) thin film solar cell for another example, the hydrogen selenide gas is also used for the reaction with copper, zinc and tin in the vertical heat treating furnace of the present invention to produce the CZTS thin film solar cells.

## Claims

1. A vertical heat treating furnace comprising:
an outer body (10) having an exterior wall (11) and an interior well (12), thereby forming a first receiving space, and having a first side (101) and a second side (102) opposite to said first side (101), wherein said first side (101) being provided with an opening of said first receiving space, and said second side (102) is a sealed side (13);
an inner body (20) being spaced and fixed in said first receiving space of said outer body (10), said inner body (20) having an outer wall (21) and an inner wall (22), thereby forming a second receiving space, having a third side (201) and a fourth side (202) opposite to said third side (201), a part of said third side (201) being connected with said first side (101) by a lower sealed side (14) thereby forming an opening of said second receiving space, and said fourth side (202) is a sealed side, wherein a gas circulation chamber (204) being formed between said outer wall (21) of said inner body (20) and said interior wall (12) of said outer body (10), and a reaction chamber (205) being formed inside said inner wall (22) of said inner body (20);
a gate door (1001) having an outer surface (1005) and an inner surface (1003), being contacted with said opening of said second receiving space of said third side (201) by said inner surface (1003), thereby either of said gas circulation chamber (204) and said reaction chamber (205) being an independent chamber;
a gas supplying mechanism (40) constituted by a plurality of gas pipes (41), said plurality of gas pipes (41) passing through said outer surface (1005) and said inner surface (103) of said gate door (1001) and being adapted to introduce gases into said gas circulation chamber (204) and said reaction chamber (205) via said opening of said second receiving space and said lower sealed side (14); and **characterized by**
a controller (50) being set outside said outer body (10) for controlling a gas supplying mechanism (40) adapted to control a supply amount of a first gas and a second gas into said gas circulation chamber (204) and said reaction chamber (205) in a way to form a first pressure (P₁) in said gas circulation chamber (204) and to form a second pressure (P₂) in said reaction chamber (205), wherein the first pressure (P₁) is greater than the second pressure (P₂).

2. The vertical heat treating furnace of claim 1, wherein said gas circulation chamber (204) is provided with at least one first sensor (103) for determining the first pressure (P₁).

3. The vertical heat treating furnace of claim 1, wherein said reaction chamber (205) is provided with at least one second sensor (203) for determining the second pressure (P₂).

4. The vertical heat treating furnace of claim 2, wherein said first sensor (103) is a pressure gauge.

5. The vertical heat treating furnace of claim 3, wherein said second sensor (203) is a pressure gauge.

6. The vertical heat treating furnace of claim 2, wherein said first sensor (103) is a gas density analyzer.

7. The vertical heat treating furnace of claim 3, wherein said second sensor (203) is a gas density analyzer.

8. The vertical heat treating furnace of claim 1, further comprising a heating mechanism (30) being fixed and contacted with said outer wall (21) of said inner body (20).

9. The vertical heat treating furnace of claim 8, wherein said heating mechanism (30) is a carbon heater or a halogen lamp heater.

10. The vertical heat treating furnace of claim 1, wherein said first pressure (P₁) and said second pressure (P₂) is greater than 101325Pa (1 atm).

11. The vertical heat treating furnace of claim 2, wherein each of said first sensor (103) in the gas circulation chamber (204) is connected with the controller (50).

12. The vertical heat treating furnace of claim 3, wherein each of said second sensor (203) in the said reaction chamber (205) is connected with the controller (50).

## Patentansprüche

1. Vertikaler Wärmebehandlungsofen umfassend:
einen Außenkörper (10), der eine Außenwand (11) und eine Innenwand (12) aufweist, wodurch ein erster Aufnahmeraum gebildet wird, und weiter eine erste Seite (101) und eine zur ersten Seite (101) entgegengesetzte zweite Seite (102) aufweist, wobei besagte erste Seite (101) mit einer Öffnung des besagten ersten Aufnahmeraums ausgebildet ist, und wobei besagte zweite Seite (102) eine abgedichtete Seite (13) ist,
einen Innenkörper (20), der beabstandet von dem Außenkörper (10) und in besagtem ersten Aufnahmeraum des besagten Außenkörpers (10) fixiert ist,
wobei besagter Innenkörper (20) eine Außenwand (21) und eine Innenwand (22) aufweist, wodurch ein zweiter Aufnahmeraum gebildet wird, der eine dritte Seite (201) und eine der besagten dritten Seite (201) gegenüber liegende vierte Seite (202) aufweist, wobei ein Teil der besagten dritten Seite (201) mit der besagten ersten Seite (101) über eine untere abgedichtete Seite (14) verbunden ist, wodurch eine Öffnung des besagten zweiten Aufnahmeraums gebildet wird, und wobei besagte vierte Seite (202) eine abgedichtete Seite ist,
wobei eine Gaszirkulationskammer (204) zwischen besagter Außenwand (21) des besagten Innenkörpers (20) und besagter Innenwand (12) des besagten Außenkörpers (10) gebildet ist, und wobei eine Reaktionskammer (205) innerhalb der besagten Innenwand (22) des besagten Innenkörpers (20) gebildet ist,
eine Öffnungsklappe (1001), die einen Außenfläche (1005) und eine Innenfläche (1003) umfasst, und die über die besagte Innenfläche (1003) mit der besagten Öffnung des besagten zweiten Aufnahmeraums der besagten dritten Seite (201) verbunden ist, wodurch jede der besagten Gaszirkulationskammer (204) und der besagten Reaktionskammer (205) eine unabhängige Kammer bildet,
einen Gasversorgungsmechanismus (40), der durch eine Vielzahl von Gasleitungen gebildet ist, wobei besagte Vielzahl von Gasleitungen (41) durch besagte Außenfläche (1005) und besagte Innenfläche (103) der besagten Öffnungsklappe (1001) hindurch verlaufen und ausgestaltet sind, Gase in besagte Gaszirkulationskammer (204) und besagte Reaktionskammer (205) über besagte Öffnung des besagten zweiten Aufnahmeraums und der besagten unteren abgedichteten Seite (14) zu leiten;
**dadurch gekennzeichnet, dass**
eine Kontroller (50) außerhalb des besagten Außenkörpers (10) zum kontrollieren eines Gasversorgungsmechanismus (40) ausgebildet ist, der geeignet ist, eine Versorgungsmenge eines ersten Gases und eines zweiten Gases in die besagte Gaszirkulationskammer (204) und besagte Reaktionskammer (205) derart zu kontrollieren, dass ein erster Druck (P₁) in besagter Gaszirkulationskammer (204) und ein zweiter Druck (P₂) in besagter Reaktionskammer (205) erzeugt wird, wobei der erste Druck (P₁) größer als der zweite Druck (P₂) ist.

2. Vertikaler Wärmebehandlungsofen nach Anspruch 1, wobei besagte Gaszirkulationskammer (204) mit mindestens einem ersten Sensor (103) zur Bestimmung des ersten Drucks (P₁) ausgestaltet ist.

3. Vertikaler Wärmebehandlungsofen nach Anspruch 1, wobei besagte Reaktionskammer (205) mit mindestens einem zweiten Sensor (203) zur Bestimmung des zweiten Drucks (P₂) ausgestaltet ist.

4. Vertikaler Wärmebehandlungsofen nach Anspruch 2, wobei besagter erster Sensor (103) ein Druckmesser ist.

5. Vertikaler Wärmebehandlungsofen nach Anspruch 3, wobei besagter zweiter Sensor (203) ein Druckmesser ist.

6. Vertikaler Wärmebehandlungsofen nach Anspruch 2, wobei besagter erster Sensor (103) ein Gasdichtenanalysemessgerät ist.

7. Vertikaler Wärmebehandlungsofen nach Anspruch 3, wobei besagter zweiter Sensor (203) ein Gasdichtenanalysemessgerät ist.

8. Vertikaler Wärmebehandlungsofen nach Anspruch 1, weiter umfassend einen Heizmechanismus (30), der an besagter Außenwand (21) des besagten Innenkörpers (20) befestigt und mit dieser kontaktiert ist.

9. Vertikaler Wärmebehandlungsofen nach Anspruch 8, wobei besagter Heizmechanismus (30) ein Kohlenstoffheizer oder ein Halogenlampenheizer ist.

10. Vertikaler Wärmebehandlungsofen nach Anspruch 1, wobei besagter erster Druck (P₁) und besagter zweiter Druck (P₂) größer als 101325 Pa (1 atm) sind.

11. Vertikaler Wärmebehandlungsofen nach Anspruch 2, wobei jeder der ersten Sensoren (103) in der Gaszirkulationskammer (204) mit dem Kontroller (50) verbunden ist.

12. Vertikaler Wärmebehandlungsofen nach Anspruch 3, wobei jeder der zweiten Sensoren (203) in der Reaktionskammer (205) mit dem Kontroller (50) verbunden ist.

## Revendications

1. Four de traitement thermique vertical, comprenant :
un corps extérieur (10) présentant une paroi extérieure (11) et une paroi intérieure (12), formant ainsi un premier espace de réception, et présentant un premier côté (101) et un second côté (102) opposé audit premier côté (101),
ledit premier côté (101) étant prévu avec une ouverture dudit premier espace de réception, et ledit second côté (102) est un côté étanchéifié (13) ;
un corps intérieur (20) espacé et fixé dans ledit premier espace de réception dudit corps extérieur (10), ledit corps intérieur (20) présentant une paroi extérieure (21) et une paroi intérieure (22), formant ainsi un second espace de réception, présentant un troisième côté (201) et un quatrième côté (202) opposé audit troisième côté (201), une partie dudit troisième côté (201) étant reliée audit premier côté (101) par un côté inférieur étanchéifié (14) formant ainsi une ouverture dudit second espace de réception, et ledit quatrième côté (202) est un côté étanchéifié, une chambre de circulation gazeuse (204) étant formée entre ladite paroi extérieure (21) dudit corps intérieur (20) et ladite paroi intérieure (12) dudit corps extérieur (10), et une chambre de réaction (205) étant formée à l'intérieur de ladite paroi intérieure (22) dudit corps intérieur(20) ;
une porte d'entrée (1001) présentant une surface extérieure (1005) et une surface intérieure (1003), étant en contact avec ladite ouverture dudit second espace de réception dudit troisième côté (201) par ladite surface intérieure (1003), chacune desdites chambre de circulation gazeuse (204) et chambre de réaction (205) étant une chambre indépendante ;
un mécanisme d'alimentation en gaz (40) constitué par une pluralité de tuyaux de gaz (41), ladite pluralité de tuyaux de gaz (41) traversant ladite surface extérieure (1005) et ladite surface intérieure (1003) de ladite porte d'entrée (1001) et étant adaptée pour introduire des gaz dans ladite chambre de circulation gazeuse (204) et ladite chambre de réaction (205) via ladite ouverture dudit second espace de réception et dudit côté inférieure étanchéifié (14) ; et
**caractérisé par**
un contrôleur (50) disposé à l'extérieur dudit corps extérieur (10) pour contrôler un mécanisme d'alimentation en gaz (40) adapté pour contrôler une quantité d'alimentation d'un premier gaz et d'un second gaz dans ladite chambre de circulation gazeuse (204) et ladite chambre de réaction (205) de manière à former une première pression (P₁) dans ladite chambre de circulation gazeuse (204) et à former une seconde pression (P₂) dans ladite chambre de réaction (205), la première pression (P₁) étant supérieure à la seconde pression (P₂).

2. Four de traitement thermique vertical selon la revendication 1, dans lequel ladite chambre de circulation gazeuse (204) est prévue avec au moins un premier capteur (103) pour déterminer la première pression (P₁).

3. Four de traitement thermique vertical selon la revendication 1, dans lequel ladite chambre de réaction (205) est prévue avec au moins un second capteur (203) pour déterminer la seconde pression (P₂).

4. Four de traitement thermique vertical selon la revendication 2, dans lequel ledit premier capteur (103) est un manomètre.

5. Four de traitement thermique vertical selon la revendication 3, dans lequel ledit second capteur (203) est un manomètre.

6. Four de traitement thermique vertical selon la revendication 2, dans lequel ledit premier capteur (103) est un analyseur de densité du gaz.

7. Four de traitement thermique vertical selon la revendication 3, dans lequel ledit second capteur (203) est un analyseur de densité du gaz.

8. Four de traitement thermique vertical selon la revendication 1, comprenant en outre un mécanisme de chauffage (30) qui est fixé à ladite paroi extérieure (21) dudit corps intérieur (20) et en contact avec celle-ci.

9. Four de traitement thermique vertical selon la revendication 8, dans lequel ledit mécanisme de chauffage (30) est un élément chauffant à charbon ou un élément chauffant par lampe halogène.

10. Four de traitement thermique vertical selon la revendication I, dans lequel ladite première pression (P₁) et ladite seconde pression (P₂) sont supérieures à 101325 Pa (1 Atm).

11. Four de traitement thermique vertical selon la revendication 2, dans lequel chaque premier capteur (103) dans la chambre de circulation gazeuse (204) est relié au contrôleur (50).

12. Four de traitement thermique vertical selon la revendication 3, dans lequel chaque second capteur (203) dans ladite chambre de réaction (205) est relié au contrôleur (50).
